# EUROPEAN PATENT APPLICATION

(11) **EP 2 330 642 A2**
(43) Date of publication of application: **08.06.2011**
(21) Application number: 10193393.5
(22) Date of filing: 01.12.2010
(51) Int. Cl.: H01L 33/14

(54) **Light emitting device, method of manufacturing the same, light emitting device package, and lighting system**

(30) Priority: 02.12.2009 KR 20090118720
(71) Applicant: LG Innotek Co., Ltd., Seoul 100-714 (KR)
(72) Inventor: Jung, Sung Hoon, Seoul 100-714 (KR); Kim, Jun Hyoung, Seoul 100-714 (KR)
(74) Representative: Cabinet Plasseraud

(57) **Abstract**

Disclosed is a light emitting device, a method of manufacturing the same, a light emitting device package, and a lighting system. The light emitting device includes a first conductive semiconductor layer including first conductive impurities, a second conductive semiconductor layer including second conductive impurities different from the first conductive impurities, an active layer between the first conductive semiconductor layer and the second conductive semiconductor layer, and an AlInN-based semiconductor layer interposed between the active layer and the second conductive semiconductor layer while making contact with both of the active layer and the second conductive semiconductor and including the second conductive impurities.

## Description

The present application claims priority of Korean Patent Application No. 10-2009-0118720 filed on December 02, 2009, which is hereby incorporated by reference in its entirety.

### BACKGROUND

The embodiment relates to a light emitting device, a method of manufacturing the same, a light emitting device package, and a lighting system.

A light emitting diode (LED) has been mainly used as a light emitting device. The LED converts electrical signals into the form of light such as a UV ray or a visible ray by using the characteristic of the compound semiconductor.

Recently, as the light efficiency of the LED is increased, the LED has been used in various electronic and electric apparatuses such as display appliances or lighting appliances.

### SUMMARY

The embodiment provides a light emitting device having a novel structure, a method of manufacturing the same, a light emitting device package, and a lighting system.

The embodiment provides a light emitting device capable of increasing internal quantum efficiency, a method of manufacturing the same, a light emitting device package, and a lighting system.

The embodiment provides a light emitting device capable of increasing light efficiency, a method of manufacturing the same, a light emitting device package, and a lighting system.

According to the embodiment, a light emitting device includes a first conductive semiconductor layer including first conductive impurities, a second conductive semiconductor layer including second conductive impurities different from the first conductive impurities, an active layer between the first conductive semiconductor layer and the second conductive semiconductor layer, and an AlInN-based semiconductor layer interposed between the active layer and the second conductive semiconductor layer, wherein the AlInN-based semiconductor layer contacts with both of the active layer and the second conductive semiconductor and includes the second conductive impurities.

According to the embodiment, a method of manufacturing a light emitting device includes forming a first conductive semiconductor layer, forming an active layer on the first conductive semiconductor layer, forming an AlInN-based semiconductor layer directly formed on the active layer and including second conductive impurities, and forming a second conductive semiconductor layer on the AlInN-based semiconductor layer.

### BRIEF DESCRIPTION OF THE DRAWINGS

FIG. 1 is a view showing a light emitting device according to a first embodiment;
FIG. 2 is a view showing a light emitting device according to a second embodiment;
FIG. 3 is a view showing bandgap energy of a light emitting device according to the first embodiment;
FIG. 4 is a graph representing light emission efficiency as a function of current density when an AlInN layer is used as the electron blocking layer in the light emitting device according to the embodiment, and when a conventional AlGaN layer is used as an electron blocking layer in the light emitting device according to the embodiment;
FIG. 5 is a graph representing light emission efficiency as a function of current density according to the variation in the content of In of an AlInN layer when the AlInN layer is used as an electron blocking layer in the light emitting device according to the embodiment;
FIG. 6 is a graph representing light emission efficiency as a function of current density when an AlInN layer containing 17% of In is interposed between an active layer and a p-GaN layer in the light emitting device according to the embodiment, and when a p-GaN layer having a thickness of about 40nm is disposed between the active layer and the AlInN layer containing 17% of In in the light emitting device according to the embodiment;
FIG. 7 is a view showing a light emitting device package in which a light emitting device according to the embodiments is installed;
FIG. 8 is a view showing a backlight unit including a light emitting device or a light emitting device package according to the embodiment; and
FIG. 9 is a perspective view showing a light emitting device or a light emitting device package according to the embodiment.

### DETAILED DESCRIPTION OF THE EMBODIMENTS

In the description of the embodiments, it will be understood that, when a layer (or film), a region, a pattern, or a structure is referred to as being "on" or "under" another substrate, another layer (or film), another region, another pad, or another pattern, it can be "directly" or "indirectly" over the other substrate, layer (or film), region, pad, or pattern, or one or more intervening layers may also be present. Such a position of the layer has been described with reference to the drawings.

The thickness and size of each layer shown in the drawings may be exaggerated, omitted or schematically drawn for the purpose of convenience or clarity. In addition, the size of elements does not utterly reflect an actual size.

Hereinafter, a light emitting device, a light emitting device package, and a method of manufacturing the light emitting device according to embodiments will be described in detail.

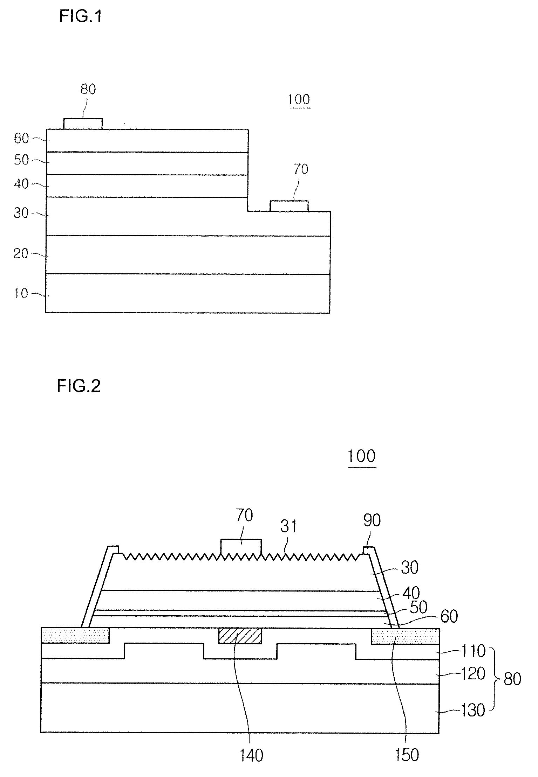

FIG. 1 is a view showing a light emitting device according to a first embodiment, and especially showing a horizontal type light emitting device.

Referring to FIG. 1, the light emitting device 100 according to a first embodiment includes a substrate 10, an undoped nitride layer 20 including a buffer layer (not shown) on the substrate 10, a first conductive semiconductor layer 30 on the undoped nitride layer 20, an active layer 40 on the first conductive semiconductor layer 30, an electron blocking layer 50 on the active layer 40, and a second conductive semiconductor layer 60 on the electron blocking layer 50. In addition, a first electron layer 70 is formed on the first conductive semiconductor layer 30, and a second electrode layer 80 is formed on the second conductive semiconductor layer 60.

An InGaN/GaN superlattice structure or an InGaN/InGaN superlattice structure doped with first conductive impurities may be formed between the first conductive semiconductor layer 30 and the active layer 40.

For example, the substrate 10 may include at least one of Al₂O₃, SiC, GaAs, GaN, ZnO, Si, GaP, InP, and Ge, but the embodiment is not limited thereto. A plurality of protrusion patterns may be formed on a top surface of the substrate 10, and may scatter the light emitted from the active layer 40 to increase light efficiency. For example, the protrusion patterns may have one of a semispherical shape, a polygonal shape, a triangular pyramid shape, and a nano-column shape.

The buffer layer (not shown) is formed on the substrate 10. For example, the buffer layer may include a GaN-based material, or may have the stack structure such as AlInN/GaN, AlInN/GaN, or AlInGaN/InGaN/GaN.

The undoped nitride layer 20 is formed on the buffer layer (not shown) . For example, the undoped nitride layer 20 may include an undoped GaN layer.

The first conductive semiconductor layer 30 may include first conductive impurities, for example, an N type semiconductor layer. The first conductive semiconductor layer 30 may include a semiconductor material of InₓAl_{y}Ga_{1-x-y}N (0≤ₓ≤1, O≤y≤1, 0≤_{x+y}≤1). For example, the first conductive semiconductor layer 30 may include material selected from the group consisting of InAlGaN, GaN, AlGaN, AlInN, InGaN, AlN, and InN. The first conductive semiconductor layer 30 may be doped with N type impurities such as Si, Ge, and Sn.

The first conductive semiconductor layer 30 can be formed by injecting trimethyl gallium (TMGa) gas, ammonia (NH₃) gas, and silane (SiH₄) gas into the chamber together with hydrogen (H₂) gas.

The active layer 40 emits the light based on the band gap difference of the energy band according to material constituting the active layer 40 through the recombination of electrons (or holes) injected through the first conductive semiconductor layer 3 0 and holes (or electrons) injected through the second conductive semiconductor layer 50. The active layer 40 may have a single quantum well structure, a multiple quantum well (MQW) structure, a quantum dot structure, or a quantum wire structure, but the embodiment is not limited thereto.

The active layer 40 may include semiconductor material having a compositional formula of InₓAl_{y}Ga_{1-x-y}N (O≤ₓ≤1, 0≤_{y}≤1, 0≤_{x+y}≤1) . If the active layer 40 has the MQW structure, the active layer 40 may include a stack structure of InGaN well/GaN barrier layers.

The active layer 40 can be formed by injecting TMGa gas, trimethyl indium (TMIn) gas, and NH3 gas, into the chamber together with H₂ gas.

The electron blocking layer 50 is formed on the active layer 40, and may make contact with the active layer 40 and the second conductive semiconductor layer 60.

The electron blocking layer 50 may include an AlInN-based semiconductor layer including P type impurities such as Mg. The electron blocking layer 50 may be directly formed on the active layer 40, or may be formed on the active layer 40 while interposing another semiconductor layer between the electron blocking layer 50 and the active layer 40.

The electron blocking layer 50 may be formed by injecting trimethyl aluminum (TMAl) gas, TMIn gas, NH₃ gas, and bis(ethylcyclopentadienyl)magnesium ((EtCp₂Mg) {Mg(C₂H₅C₅H₄)₂}) gas into a chamber together with H₂ gas.

The second conductive semiconductor layer 60 is formed on the electron blocking layer 50. For example, the second conductive semiconductor layer 60 may include a P type semiconductor layer. The second conductive semiconductor layer 60 may include semiconductor material having a compositional formula of InₓAl_{y}Ga_{1-x-y}N (0≤ₓ≤1, 0≤_{y}≤1, 0≤_{x+y}≤1). For instance, the second conductive semiconductor layer 60 may be selected from the group consisting of InAlGaN, GaN, AlGaN, InGaN, AlInN, AlN, and InN, and may be doped with P type dopants such as Mg, Zn, Ca, Sr, and Ba.

The second conductive semiconductor layer 60 may be formed by injecting TMGa gas, NH₃ gas, and (EtCp₂Mg) {Mg(C₂H₅C₅H₄)₂} gas into a chamber together with H₂ gas.

Meanwhile, the first conductive semiconductor layer 30 may include a P type semiconductor layer, and the second conductive semiconductor layer 60 may include an N type semiconductor layer. In addition, a third conductive semiconductor layer (not shown) including an N type semiconductor layer or a P type semiconductor layer may be formed on the second conductive semiconductor layer 60. Accordingly, a light emitting structure layer including the first conductive semiconductor layer 30, the active layer 40, and the second conductive semiconductor layer 60 may have at least one of NP, PN, NPN, and PNP junction structures. In addition, the doping concentration of impurities in the first and second conductive semiconductor layers 30 and 60 may be uniform or irregular. In other words, the light emitting structure layer may have various structures, but the embodiment is not limited thereto.

The light emitting device 100 may include a GaN-based light emitting diode to emit blue light, which has a wavelength band in the range of about 450nm to about 480nm, preferably, the central wavelength of about 465nm, and has the FWHM (full width at half maximum) of about 15 nm to about 40 nm.

In order to manufacture the light emitting device 100, after forming the undoped nitride layer 20, the first conductive semiconductor layer 30, the active layer 40, the electron blocking layer 50, and the second conductive semiconductor layer 60 on the substrate 10, a mesa etching is performed to selectively remove the first conductive semiconductor layer 30, the active layer 40, the electron blocking layer 50, and the second conductive semiconductor layer 60. The first electrode layer 70 is formed on the first conductive semiconductor layer 30, and the second electrode layer 80 is formed on the second conductive semiconductor layer 60.

Meanwhile, in order to improve internal quantum efficiency, the light emitting device 100 according to a first embodiment includes the electron blocking layer 50 interposed between the active layer 40 and the second conductive semiconductor layer 60.

In order to improve the performance to emit light of the light emitting device 100, electrons and holes have to be injected into the active layer 40 as effectively as possible, and recombined with each other without leaking into another region to generate light.

Electrons among holes and electrons injected into the active layer 40 move more rapidly than holes, and hot electrons made by thermal energy generated from the active layer 40 deviate from the active layer 40 so that the hot electrons leak into the second conductive semiconductor layer 60. In order to prevent electrons from leaking into the second conductive semiconductor layer 60, the electron blocking layer 50 having the band gap greater than that of the active layer 40 is formed to act as the barrier of the electrons.

In the light emitting device 100 according to the first embodiment, the electron blocking layer 50 may be formed with the compositional formula of Al₁₋ₓInₓN : Mg (0<x<0.35), in which more great effect is represented when the range of x is 0.15<x<0.19. In particular, when the x is 0.17, the electron blocking layer 50 is lattice-matched with GaN.

Although the electron blocking layer 50 conventionally includes AlGaN, the AlGaN is difficult to participate in P type doping due to a lattice defect caused by the lattice constant mismatch with the active layer 40, and a crystal cannot be grown with superior conductivity and crystalline due to the lattice defect caused by the lattice constant mismatch and great activation energy of the dopants. This forms an energy blocking layer in a valance band, thereby preventing holes from moving to a multiple quantum well layer of the active layer 40. The hole blocking layer is increased as a Fermi level formed by doping is increased higher than that of the valance band.

Therefore, in the light emitting device 100 according to the first embodiment, the electron blocking layer 50 includes ternary mixed compounds of AlInN so that lattice constant mismatch with the a GaN layer can be removed. In addition, hole mobility can be increased by using a local energy site between the ternary mixed compounds of AlInN, and carrier concentration can be increased due to activation energy lower than that of the AlGAN. As a result, the structure and electrical characteristics can be improved, so that the light emitting efficiency of the active layer 40 can be improved.

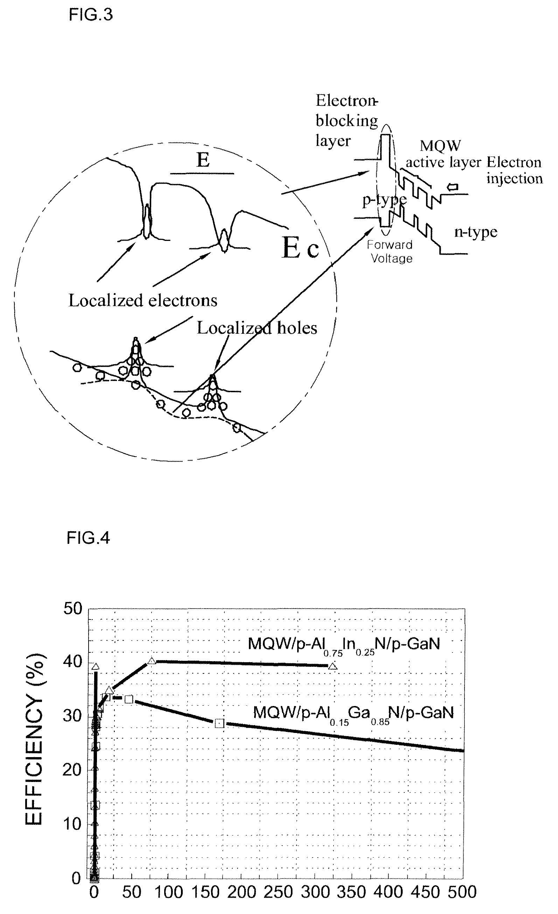

FIG. 3 is a view showing bandgap energy of the light emitting device 10 according to the first embodiment.

Referring to FIG. 3, the electron blocking layer 50 may include an AlInN layer. Since the AlInN layer includes In, a phase-separation such as Spinodal occurs in a solid state due to the low solubility of In. Accordingly, a crystal containing a great amount of In is locally formed in an AlInN layer due to the phase-separation. The energy bandgap of the crystal is lower than desired AlInN bandgap energy, and a local energy site is formed in the AlInN layer. Therefore, a compound semiconductor having an electrical characteristic, in which localized electrons and localized holes are accumulated, is formed in the local energy site.

When the AlInN layer includes 17% of In, the AlInN layer is lattice-matched with the GaN layer, so that lattice defects can be prevented in the light emitting device. In this case, the AlInN layer is advantageous in terms of the acquisition of higher doping efficiency. When the range of x of Al₁₋ₓInₓN:Mg is 0 <ₓ< 0.17, bandgap energy of the AlInN layer may be in the range of 6.2eV to 4.92eV. When the x is 0.17, the AlInN layer has the bandgap energy of 4.92eV in theory. However, actually, the bandgap energy of the AlInN layer having the mixture of In may be measured to 3.7eV due to Bowing.

As shown in FIG. 3, when a forward voltage is applied, bandgap energy is changed due to voltage direction. Accordingly, when the AlInN layer is interposed between the active layer 40 (MQW active layer) and the second conductive semiconductor layer 60, holes accumulated in the local energy site of the valance band may be easily supplied to the active layer 40 due to the sufficient high energy blocking layer against electrons and Kronig-Penny model. Accordingly, the internal quantum effect of the active layer 40 can be increased.

FIG. 2 is a view showing the light emitting device 100 according to a second embodiment. FIG. 2 discloses a vertical type light emitting device 100. Hereinafter, the light emitting device 100 according to the second embodiment will be described while focusing on the difference from the light emitting device according to the first embodiment in order to avoid redundancy.

Referring to FIG. 2, the light emitting device 100 according to the second embodiment includes the second electrode layer 80, the second conductive semiconductor layer 60 on the second electrode layer 80, the electron blocking layer 50 on the second conductive semiconductor layer 60, the active layer 40 on the electron blocking layer 50, the first conductive semiconductor layer 30 on the active layer 40, and the first electrode layer 70 on the first conductive semiconductor layer 30.

An InGaN/GaN superlattice structure or an InGaN/InGaN superlattice structure including the first conductive impurities may be interposed between the first conductive semiconductor layer 30 and the active layer 40.

A light extracting structure 31 having the shape of a column or the shape of a hole may be formed on a top surface of the first conductive semiconductor layer 30. The light extracting structure 31 can effectively extract light emitted from the active layer 40 to the outside. For example, the light extracting structure 31 may have one of a semispherical shape, a polygonal shape, a triangular pyramid shape, and a nano-column shape. The light extracting structure may include a photonic crystal.

The second electrode layer 80 includes a conductive support substrate 130, a reflective layer 120 on the conductive support substrate 130, and an ohmic contact layer 110 on the reflective layer 120. The conductive support substrate 130 may include at least one selected from the group consisting of Cu, Ni, Mo, Al, Au, Nb, W, Ti, Cr, Ta, Pd, Pt, Si, Ge, GaAs, ZnO, and SiC, and the reflective layer 120 may include at least one selected from the group consisting of Ag, the alloy of Ag, Al, and the alloy of Al. An adhesion metal layer may be interposed between the conductive support substrate 130 and the reflective layer 120 to improve the interface adhesion strength between the conductive support substrate 130 and the reflective layer 120. The adhesion metal layer may include one or at least two selected from the group consisting of Cu, Ni, Ag, Mo, Al, Au, Nb, W, Ti, Cr, Ta, Al, Pd, Pt, Si, Al-Si, Ag-Cd, Au-Sb, Al-Zn, Al-Mg, Al-Ge, Pd-Pb, Ag-Sb, Au-In, Al-Cu- Si, Ag-Cd-Cu, Cu-Sb, Cd-Cu, Al-Si-Cu, Ag-Cu, Ag-Zn, Ag-Cu-Zn, Ag-Cd-Cu-Zn, Au-Si, Au-Ge, Au-Ni, Au-Cu, Au-Ag-Cu, Cu-Cu₂O, Cu-Zn, Cu-P, Ni-P, Ni-Mn-Pd, Ni-P, and Pd-Ni. The ohmic contact layer 110 may include transparent metallic oxide. For example, the ohmic contact layer 110 may have a single layer structure or a multiple layer structure including at least one selected from the group consisting of ITO(indium tin oxide), IZO (indium zinc oxide), IZTO(indium zinc tin oxide), IAZO (indium aluminum zinc oxide), IGZO(indium gallium zinc oxide), IGTO(indium gallium tin oxide), AZO(aluminum zinc oxide), ATO(antimony tin oxide), GZO(gallium zinc oxide), IrOₓ, RuOₓ, RuOₓ/ITO, Ni, Ag, Ni/IrOₓ/Au, and Ni/IrOₓ/Au/ITO. Only one of the reflective layer 120 and the ohmic contact layer 110 may be formed.

A current blocking layer 140 may be formed between the second conductive semiconductor layer 60 and the second electrode layer 80. At least portion of the current blocking layer 140 is overlapped with the first electrode layer 70 in a vertical direction. The current blocking layer 140 may be formed of an insulating material or a material forming a schottky contact with the second conductive semiconductor layer 60. Thus, the current blocking layer 140 may prevent a current from concentrately flowing into the shortest distance between the second electrode layer 80 and the first electrode layer 70 to improve the light efficiency of the light emitting device 100.

A protection layer 150 may be disposed in a circumference region of a top surface of the second electrode layer 80. That is, the protection layer 150 may be disposed in a circumference region between the second conductive semiconductor layer 60 and the second electrode layer 80. Also, the protection layer 150 may be formed of an insulation material such as ZnO or SiO₂. A portion of the protection layer 150 may be disposed between the second electrode layer 80 and the second conductive semiconductor layer 60 to vertically overlap the second conductive semiconductor layer 60.

The protection layer 150 increases a distance of a side surface between the second electrode layer 80 and the active layer 40. Thus, the protection layer 150 may prevent the second electrode layer 80 and the active layer 40 from being electrically short-circuited to each other.

Also, when an isolation etching process is performed on the protection layer 150 to separate the light emitting structure layer into unit chips in a chip separation process, fragments may be generated from the second electrode layer 80. As a result, the fragments are attached between the second conductive semiconductor layer 60 and the active layer 40 or between the active layer 40 and the first conductive semiconductor layer 30 to prevent them from being electrically short-circuited to each other. The protection layer 150 may be formed of a material, which is not broken or does not generate fragments or a material, which does not cause an electric short-circuit even though it is broken somewhat or generates a small amount of fragments.

A passivation layer 90 may be formed on the first conductive semiconductor layer 30, the active layer 40, the electron blocking layer 50, and the second conductive semiconductor layer 60. The passivation layer 90 can protect the first conductive semiconductor layer 30, the active layer 40, the electron blocking layer 50, and the second conductive semiconductor layer 60 electrically or physically.

In order to manufacture the light emitting device 100 of FIG. 2 according to the second embodiment, after forming the undoped nitride layer 20, the first conductive semiconductor layer 30, the active layer 40, the electron blocking layer 50, and the second conductive semiconductor layer 60 on the substrate 10 as shown in FIG. 1, the second electrode layer 80 is formed under the second conductive semiconductor layer 60 as shown in FIG. 2. Before forming the second electrode layer 80, the currently blocking layer 140 and the protection layer 150 can be formed on the second conductive semiconductor layer 60. Then, an isolation etching process is performed on the first conductive semiconductor layer 30, the active layer 40, the electron blocking layer 50, and the second conductive semiconductor layer 60 to separate the light emitting structure layer into unit chips in a chip separation process.

Then, after removing the substrate 10 and the undoped nitride layer 20 through a laser lift off scheme or an etching scheme, the first electrode layer 70 is formed on the first conductive semiconductor layer 30.

Meanwhile, the characteristic of the electron blocking layer 50 in the light emitting device 100 according to the second embodiment are identical to those of the electron blocking layer in the light emitting device according to the first embodiment.

FIG. 4 is a graph representing light emission efficiency as a function of current density when employing an AlInN layer as the electron blocking layer in the light emitting device according to the embodiment and when employing a conventional AlGaN layer as an electron blocking layer in the light emitting device according to the embodiment.

As shown in FIG. 4, an AlGaN layer containing 15% of Al is interposed between the active layer and the second conductive semiconductor layer to measure light emission efficiency, and an AlInN layer containing 25% of In is interposed between the active layer and the second conductive semiconductor layer to measure light emission efficiency. As measurement results, when the AlInN layer is used as an electron blocking layer, the light emission efficiency is improved.

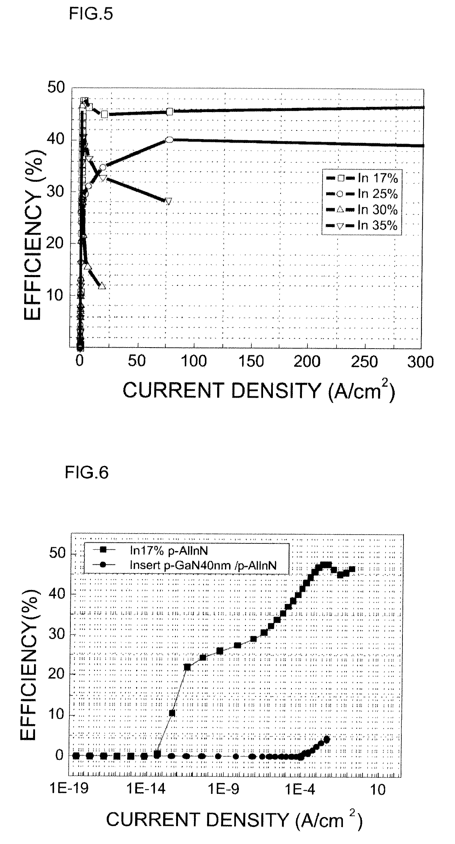

FIG. 5 is a graph representing light emission efficiency as a function of current density according to the variation in the content of In when an AlInN layer is used as an electron blocking layer in the light emitting device according to the embodiment.

As shown in Fig. 5, the best light emission efficiency is represented when the AlInN layer containing 17% of In is used as the electron blocking layer, and better light emission efficiency is represented when the AlInN layer contains 25% of In. In addition, even when the AlInN layer contains 30% or 35% of In, the light emission efficiency of the light emitting device is improved.

FIG. 6 is a graph representing light emission efficiency as a function of current density when the AlInN layer containing 17% of In is interposed between the active layer and a p-GaN layer in the light emitting device according to the embodiment, and when a p-GaN layer having a thickness of about 40nm is disposed between the active layer and the AlInN layer containing 17% of In in the light emitting device.

As shown in FIG. 6, when the second conductive layer, that is, the p-GaN layer is interposed between the active layer and the AlInN layer, the AlInN layer does not sufficiently act as the electron blocking layer due to the p-GaN layer. Accordingly, the light emission efficiency is not greatly improved. In contrast, when the AlInN layer is interposed between the active layer and the p-GaN layer, the light emission efficiency is greatly improved.

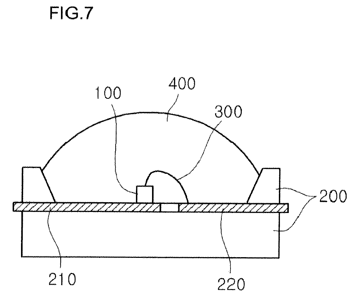

FIG. 7 is a view showing a light emitting device package including the light emitting device according to the embodiments.

Referring to FIG. 7, the light emitting device package according to the embodiment includes a package body 200, first and second electrodes 210 and 220 formed on the package body 200, the light emitting device 100 provided on the package body 200 and electrically connected to the first and second electrodes 210 and 220, and a molding member 400 that surrounds the light emitting device 100.

The package body 200 may include silicon, synthetic resin or metallic material. An inclined surface may be formed around the light emitting device 100.

The first and second electrodes 210 and 220 are electrically insulated from each other to supply power to the light emitting device 100. In addition, the first and second electrodes 210 and 220 reflect the light emitted from the light emitting device 100 to improve the light efficiency and dissipate heat generated from the light emitting device 100 to the outside.

The horizontal-type light emitting device of FIG. 1 or the vertical-type light emitting device of FIG. 2 is applicable to the light emitting device 100. The light emitting device 100 may be mounted on the package body 200 or the first and second electrodes 210 and 220.

The light emitting device 100 can be electrically connected to the first electrode 210 and/or the second electrode 220 through a wire 300. Since a vertical type light emitting device is disclosed in the embodiment, one wire 300 is used. According to another embodiment, if a horizontal-type light emitting device is used, two wires 300 may be used. If the light emitting device 100 is a flip-chip light emitting device, the wire 300 may be not used.

The molding member 400 surrounds the light emitting device 100 to protect the light emitting device 100. In addition, the molding member 400 may include luminescence material to change the wavelength of the light emitted from the light emitting device 100.

As described above, in the light emitting device according to the embodiment, an AlInN layer is interposed between the active layer and the second conductive semiconductor layer and serves as an electron blocking layer, so that the light emission efficiency of the light emitting device can be improved.

A plurality of light emitting device packages according to the embodiment may be arrayed on a substrate, and an optical member including a light guide plate, a prism sheet, a diffusion sheet, and a fluorescent sheet may be provided on the optical path of the light emitted from the light emitting device package. The light emitting device package, the substrate, and the optical member may serve as a backlight unit or a lighting unit. For instance, the lighting system may include a backlight unit, a lighting unit, an indicator, a lamp or a streetlamp.

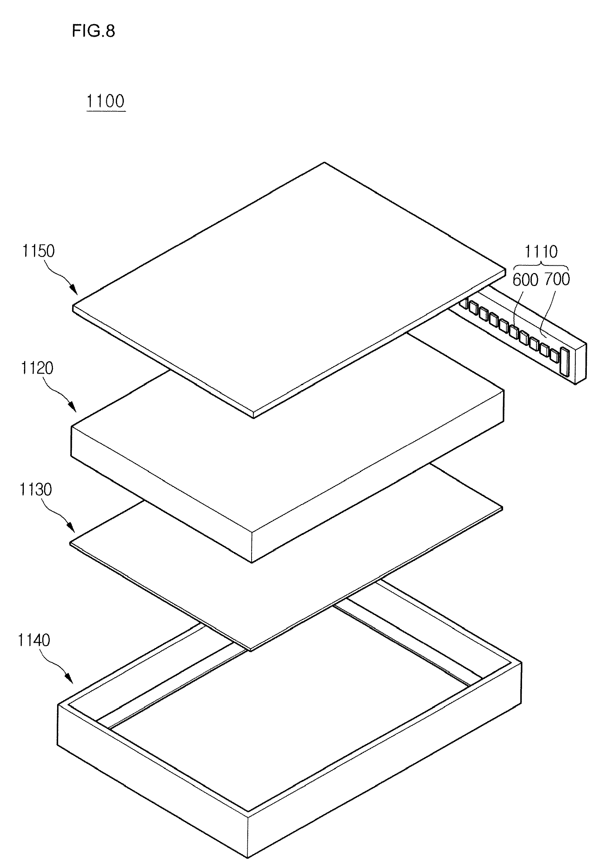

FIG. 8 is a view showing a backlight unit 1100 including the light emitting device or the light emitting device package according to the embodiment. The backlight unit 1100 shown in FIG. 8 is an example of a lighting system, but the embodiment is not limited thereto.

Referring to FIG. 8, the backlight unit 1100 includes a bottom frame 1140, a light guide member 1120 installed in the bottom frame 1140, and a light emitting module 1110 installed at one side or on the bottom surface of the light guide member 1120. In addition, a reflective sheet 1130 is disposed below the light guide member 1120.

The bottom frame 1140 has a box shape having an open top surface to receive the light guide member 1120, the light emitting module 1110 and the reflective sheet 1130 therein. In addition, the bottom frame 1140 may include metallic material or resin material, but the embodiment is not limited thereto.

The light emitting module 1110 may include a substrate 700 and a plurality of light emitting device packages 600 installed on the substrate 700. The light emitting device packages 600 provide the light to the light guide member 1120. According to the light emitting module 1110 of the embodiment, the light emitting device packages 600 are installed on the substrate 700. However, it is also possible to direct install the light emitting device 100 according to the embodiment.

As shown in FIG. 8, the light emitting module 1110 is installed on at least one inner side of the bottom frame 1140 to provide the light to at least one side of the light guide member 1120.

In addition, the light emitting module 1110 can be provided below the bottom frame 1140 to provide the light toward the bottom surface of the light guide member 1120. Such an arrangement can be variously changed according to the design of the backlight unit 1100, but the embodiment is not limited thereto.

The light guide member 1120 is installed in the bottom frame 1140. The light guide member 1120 converts the light emitted from the light emitting module 1110 into the surface light to guide the surface light toward a display panel (not shown).

The light guide member 1120 may be provided at an upper portion with a light guide plate. For instance, the light guide plate can be manufactured by using acryl-based resin, such as PMMA (polymethyl methacrylate), PET (polyethylene terephthalate), PC (polycarbonate), COC or PEN (polyethylene naphthalate) resin.

An optical sheet 1150 may be provided over the light guide member 1120.

The optical sheet 1150 may include at least one of a diffusion sheet, a light collection sheet, a brightness enhancement sheet, and a fluorescent sheet. For instance, the optical sheet 1150 has a stack structure of the diffusion sheet, the light collection sheet, the brightness enhancement sheet, and the fluorescent sheet. In this case, the diffusion sheet uniformly diffuses the light emitted from the light emitting module 1110 such that the diffused light can be collected on the display panel (not shown) by the light collection sheet. The light output from the light collection sheet is randomly polarized and the brightness enhancement sheet increases the degree of polarization of the light output from the light collection sheet. The light collection sheet may include a horizontal and/or vertical prism sheet. In addition, the brightness enhancement sheet may include a dual brightness enhancement film and the fluorescent sheet may include a transmissive plate or a transmissive film including phosphors.

The reflective sheet 1130 can be disposed below the light guide member 1120. The reflective sheet 1130 reflects the light, which is emitted through the bottom surface of the light guide member 1120, toward the light exit surface of the light guide member 1120.

The reflective sheet 1130 may include resin material having high reflectivity, such as PET, PC or PVC resin, but the embodiment is not limited thereto.

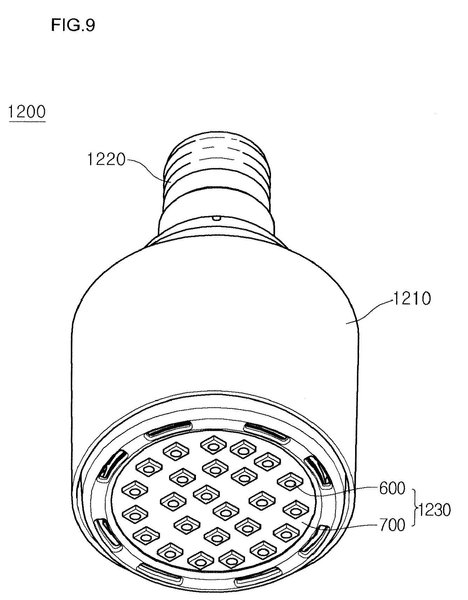

FIG. 9 is a perspective view showing a lighting unit 1200 including the light emitting device or the light emitting device package according to the embodiment. The lighting unit 1200 shown in FIG. 9 is an example of a lighting system and the embodiment is not limited thereto.

Referring to FIG. 9, the lighting unit 1200 includes a case body 1210, a light emitting module 1230 installed in the case body 1210, and a connection terminal 1220 installed in the case body 1210 to receive power from an external power source.

Preferably, the case body 1210 includes material having superior heat dissipation property. For instance, the case body 1210 includes metallic material or resin material.

The light emitting module 1230 may include a substrate 700 and at least one light emitting device package 600 installed on the substrate 700. According to the embodiment, the light emitting device package 600 is installed on the substrate 700. However, it is also possible to direct install the light emitting device 100 according to the embodiment.

The substrate 700 includes an insulating member printed with a circuit pattern. For instance, the substrate 700 includes a PCB (printed circuit board), an MC (metal core) PCB, a flexible PCB, or a ceramic PCB.

In addition, the substrate 700 may include material that effectively reflects the light. The surface of the substrate 300 can be coated with a color, such as a white color or a silver color, to effectively reflect the light.

At least one light emitting device package 600 according to the embodiment can be installed on the substrate 700. Each light emitting device package 600 may include at least one LED (light emitting diode). The LED may include a colored LED that emits the light having the color of red, green, blue or white and a UV (ultraviolet) LED that emits UV light.

The LEDs of the light emitting module 1230 can be variously arranged to provide various colors and brightness. For instance, the white LED, the red LED and the green LED can be arranged to achieve the high color rendering index (CRI). In addition, a fluorescent sheet can be provided in the path of the light emitted from the light emitting module 1230 to change the wavelength of the light emitted from the light emitting module 1230. For instance, if the light emitted from the light emitting module 1230 has a wavelength band of blue light, the fluorescent sheet may include yellow phosphors. In this case, the light emitted from the light emitting module 1230 passes through the fluorescent sheet so that the light is viewed as white light.

The connection terminal 1220 is electrically connected to the light emitting module 1230 to supply power to the light emitting module 1230. Referring to FIG. 9, the connection terminal 1220 has a shape of a socket screw-coupled with the external power source, but the embodiment is not limited thereto. For instance, the connection terminal 1220 can be prepared in the form of a pin inserted into the external power source or connected to the external power source through a wire.

According to the lighting system as described above, at least one of the light guide member, the diffusion sheet, the light collection sheet, the brightness enhancement sheet and the fluorescent sheet is provided in the path of the light emitted from the light emitting module, so that the desired optical effect can be achieved.

As described above, the lighting system includes the lighting emitting device or the light emitting device package according to the embodiment representing superior light emission efficiency, so that the lighting system can represent superior light efficiency.

Any reference in this specification to "one embodiment," "an embodiment," "example embodiment," etc., means that a particular feature, structure, or characteristic described in connection with the embodiment is included in at least one embodiment of the invention. The appearances of such phrases in various places in the specification are not necessarily all referring to the same embodiment. Further, when a particular feature, structure, or characteristic is described in connection with any embodiment, it is submitted that it is within the purview of one skilled in the art to effect such feature, structure, or characteristic in connection with other ones of the embodiments.

Although embodiments have been described with reference to a number of illustrative embodiments thereof, it should be understood that numerous other modifications and embodiments can be devised by those skilled in the art that will fall within the spirit and scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

## Claims

1. A light emitting device comprising:
a first conductive semiconductor layer including first conductive impurities;
a second conductive semiconductor layer including second conductive impurities different from the first conductive impurities;
an active layer between the first conductive semiconductor layer and the second conductive semiconductor layer; and
an AlInN-based semiconductor layer interposed between the active layer and the second conductive semiconductor layer, wherein the AlInN-based semiconductor layer contacts with both of the active layer and the second conductive semiconductor and includes the second conductive impurities.

2. The light emitting device of claim 1, wherein the AlInN-based semiconductor layer includes Al₁₋ₓInₓN:Mg (0<x<0.35).

3. The light emitting device of claim 2, wherein a range of the x is 0.15<x<0.19.

4. The light emitting device of claim 1, further comprising:
an undoped nitride layer under the first conductive semiconductor layer; and
a substrate under the undoped nitride layer.

5. The light emitting device of claim 4, further comprising:
a first electrode layer on the first conductive semiconductor layer; and
a second electrode layer on the second conductive semiconductor layer.

6. The light emitting device of claim 1, further comprising a second electrode under the second conductive semiconductor layer; and
a first electrode layer on the first conductive semiconductor layer.

7. The light emitting device of claim 1, wherein the first conductive semiconductor layer includes an N type GaN-based semiconductor layer, and the second conductive semiconductor layer is a P type GaN-based semiconductor layer.

8. The light emitting device of claim 1, further comprising an InGaN/GaN superlattice structure or an InGaN/InGaN superlattice structure including the first conductive impurities between the first conductive semiconductor layer and the active layer.

9. A method of manufacturing a light emitting device comprising:
forming a first conductive semiconductor layer;
forming an active layer on the first conductive semiconductor layer;
forming an AlInN-based semiconductor layer directly formed on the active layer and including second conductive impurities; and
forming a second conductive semiconductor layer on the AlInN-based semiconductor layer.

10. The method of claim 9, wherein the AlInN-based semiconductor layer includes Al₁₋ₓInₓN:Mg (0<x<0.35).

11. The method of claim 9, wherein a range of the x is 0.15 <x< 0.19.

12. The method of claim 9, further comprising forming an InGaN/GaN superlattice structure or an InGaN/InGaN superlattice structure including the first conductive impurities between the first conductive semiconductor layer and the active layer.

13. The method of claim 9, wherein the second conductive semiconductor layer is formed directly on the AIInN-based semiconductor layer.

14. A light emitting device package comprising:
a package body;
first and second electrodes on the package body;
a light emitting device claimed according to one of claims 1 to 12 and electrically connected to the first and second electrodes on the package body; and
a molding member surrounding the light emitting device on the package body.

15. A lighting system employing a light emitting device as a light source, the lighting system comprising:
a substrate; and
at least one light emitting device on the substrate,
wherein the light emitting device is claimed according to one of claims 1 to 12.
